# EUROPEAN PATENT SPECIFICATION

(11) **EP 2 450 948 B1**
(45) Date of publication and mention of the grant of the patent: **07.11.2018**
(21) Application number: 10794147.8
(22) Date of filing: 29.06.2010
(51) Int. Cl.: H01L 21/683, H02N 13/00

(54) **ELECTROSTATIC ATTRACTING STRUCTURE AND FABRICATING METHOD THEREFOR**
ELEKTROSTATISCH ANZIEHENDE STRUKTUR UND HERSTELLUNGSVERFAHREN DAFÜR
STRUCTURE D'ATTRACTION ÉLECTROSTATIQUE ET SON PROCÉDÉ DE FABRICATION

(30) Priority: 02.07.2009 JP 2009157460
(43) Date of publication of application: 09.05.2012
(73) Proprietor: Creative Technology Corporation, Tokyo 102-0083 (JP)
(72) Inventor: FUJISAWA, Hiroshi, Nara-shi Nara 630-8301 (JP); KAWAE, Megumu, Kawasaki-shi Kanagawa 213-0034 (JP); TATSUMI, Yoshiaki, Kawasaki-shi Kanagawa 213-0034 (JP)
(74) Representative: Vossius & Partner Patentanwälte Rechtsanwälte mbB
(86) International application number: PCT/JP2010/061059
(87) International publication number: WO 2011/001978

(56) References cited:
- EP-A2- 0 940 845
- WO-A1-2007/066572
- JP-A- 5 198 663
- JP-A- 8 033 359
- JP-A- 11 111 829
- JP-A- 2003 124 298
- JP-U- H02 135 141
- US-A- 5 532 903
- US-A1- 2007 223 173
- KENDALL ET AL: "Double-Sided Electrostatic Chuck", IP.COM JOURNAL, IP.COM INC., WEST HENRIETTA, NY, US, 1 October 1989 (1989-10-01), XP013026625, ISSN: 1533-0001

## Description

### Technical Field

The present invention relates to an electrostatic attracting structure for electrically attracting an object to be attracted, and to a method of fabricating the same. In particular, the present invention relates to an electrostatic attracting structure which forms a strongly integrated structure when being used, and also allows the structure to be changed freely in configuration after its use, and to a method of fabricating the same.

### Background Art

An electrostatic attracting structure for electrically attracting and holding an object to be attracted has a wide range of applications. For example, the electrostatic attracting structure is used for attracting and holding a semiconductor substrate or a glass substrate, or is used for attracting and holding a sheet material made of, for example, paper or resin. In the electrostatic attracting structure, electrodes are usually sandwiched by dielectric materials, and when a voltage is applied to the electrodes by an attraction power source, the electrostatic attracting structure attracts an object to be attracted by using the surface of one of the dielectric materials as an attracting surface. Further, depending on the application purpose, when the electrostatic attracting structure is used in, for example, a semiconductor fabricating process or the like, the electrostatic attracting structure is integrally bonded to a metal base provided with conduit for a coolant such as a coolant gas to pass through.

As to the attracting principle of the electrostatic attracting structure, there are known: a Coulomb force type in which an electrostatic attractive force generated between an electrode and an object to be attracted is used; a Johnsen-Rahbek force type in which an electrostatic attractive force generated between a dielectric material on which an object to be attracted is placed and the object to be attracted is used; and also a gradient force type in which, for example, a potential difference is caused to occur between two electrodes having a comb shape so as to form a non-uniform electric field, and an attractive force caused by the non-uniform electric field is used. Some structures use those attractive forces individually, and some structures use a plurality of forces in combination. Then, depending on the difference in attracting principle or the intended use of the structure, the electrode is configured to be a unipolar type or a bipolar type, and also, the kind and the characteristic of the dielectric material are selected when the electrostatic attracting structure is formed. For example, in the case of an electrostatic attracting structure which uses the Johnsen-Rahbek force, a ceramic material having a predetermined volume resistivity is used as the dielectric material, and by performing hot pressing so as to sandwich the electrode, the electrode is buried in the dielectric material. Alternatively, an insulating film is used for the purpose of preventing dust from being generated, and thermo-compression bonding is performed so that, for example, a polyimide film sandwiches an electrode with the intermediation of an adhesive film or an adhesive agent.

Further, in the case of an electrostatic attracting structure which uses the gradient force, the attractive force is generated regardless of the material of an attraction target, and hence the electrostatic attracting structure is used for attracting objects other than a semiconductor substrate. Incidentally, the inventors of the present invention have proposed an apparatus suitable for attracting a large glass substrate (see Patent Literature 1). In the case of the gradient force, usually, as the distance between the electrodes becomes narrowed, a larger attractive force is obtained. However, the close distance leads to a problem of discharge between the electrode, and thus a high voltage cannot be applied. In view of the above, the apparatus proposed by the inventors of the present invention attempts to enhance reliability of electrical insulation by using an electrostatic attracting structure in which two electrodes are arranged in different horizontal planes, when said electrostatic attracting structure is view from a side cross sectional view, and an inter-electrode insulating layer (dielectric material) is interposed therebetween.

However, with such an electrostatic attracting structure, it is necessary to process the inter-electrode insulating layer twice for its top and back surfaces in both cases where, for example, an electrode having a predetermined shape is printed by using conductive ink and where an electrode having a predetermined shape is obtained by thermal-spraying a conductive ceramic material in order to form predetermined electrodes on both surfaces of the inter-electrode insulating layer. This makes the operation complicated as a whole, and leads to a cost increase.

Meanwhile, the electrostatic attracting structure is usually formed as a strongly integrated structure by laminating and fixing the dielectric materials and the electrodes for the purpose of, for example, uniformly generating the attractive force. Further, in the case where the electrostatic attracting structure is bonded to a metal base, the electrostatic attracting structure and the metal base are firmly bonded to each other for the purpose of, for example, ensuring thermal conductivity to the object to be attracted. For those reasons, once the electrostatic attracting structure has been formed, it is difficult to partially remove and replace the attracting surface even if, for example, the attracting surface has been damaged or partially worn out. Thus, when the electrostatic attracting structure is to be restored, it is necessary to perform such processing that a dielectric material is newly formed by mechanically scraping off the whole dielectric material in the surface.

### Citation List

### Patent Literature

Patent Literature 1: WO 2005/091356 A1

JP 2003-124298 A discloses a dual electrostatic-chuck wafer stage for plasma assisted wafer processing reactors, which comprises a primary electrostatic-chuck and a secondary electrostatic-chuck placed on the primary electrostatic-chuck.

### Summary of Invention

### Technical Problem

Under such circumstances, the inventors of the present invention and the like have conducted intensive studies on means which allows obtaining with more ease an electrostatic attracting structure in which two electrodes are arranged one above the other with the intermediation of dielectric materials, and also allows the already-formed structure to be changed freely in configuration. As a result, the inventors of the present invention and the like have found that, by overlaying a plurality of sheet members each having an electrode sandwiched between dielectric materials, and integrally forming those sheet members by using an electrostatic attractive force generated between the electrodes of the sheet members, it is possible to attract an object to be attracted while maintaining the strongly integrated structure at the time of use, and also to separate those sheet members with ease by canceling the application of voltage after the use, which thus has lead to the completion of the present invention.

Therefore, it is an object of the present invention to provide an electrostatic attracting structure which allows a strongly integrated structure to be maintained when used, and also allows the structure to be changed freely in configuration after the use.

Further, it is another object of the present invention to provide a method of fabricating an electrostatic attracting structure, which enables obtaining an electrostatic attracting structure in which electrodes are arranged one above the other with the intermediation of dielectric materials easily and reliably, and allows the structure to be changed freely in configuration after the use.

### Solution to Problem

That is, according to the present invention, there is provided an electrostatic attracting structure, which electrically attracts an object to be attracted when used, including: a plurality of sheet members each having an electrode which is sandwiched between two dielectric materials; and at least one attraction power source, in which the plurality of sheet members are stacked, and by applying a voltage between the electrodes of facing sheet members by the at least one attraction power source, the facing sheet members are electrically attracted and fixed, when the electrostatic attracting structure is used, the dielectric materials of both of outermost sheet members including a sheet member corresponding to an outermost top surface layer and a sheet member corresponding to an outermost back surface layer attract the object to be attracted, and after the use, the stacked plurality of sheet members are made separable from one another by canceling the application of the voltage.

Further, according to the present invention, there is provided a method of fabricating the above-mentioned electrostatic attracting structure, including: stacking a plurality of sheet members by subjecting the plurality of sheet members to positioning among one another; electrically attracting and fixing facing sheet members and forming the facing sheet members into an integrated structure by applying a voltage between electrodes of the facing sheet members by an attraction power source; and making the stacked plurality of sheet members separable from one another after the application of the voltage is canceled.

The electrostatic attracting structure of the present invention includes the plurality of sheet members and the at least one attraction power source, and, by applying the voltage between the electrodes of the facing sheet members from the attraction power source while stacking the plurality of sheet members, the sheet members are attracted to each other due to the electrostatic attractive force generated between the electrodes of the facing sheet members, with the result that the electrostatic attracting structure is formed integrally. Specifically, the sheet members each have the electrode sandwiched between the two dielectric materials, and are configured as follows. When the voltage is applied by the attraction power source, the electrostatic attractive force is caused to occur between the electrodes of the facing sheet members, and also, the object to be attracted can be attracted to any one of or both of the sheet members (hereinbelow, referred to as "outermost sheet members") positioned in outermost layers on the top surface side and the back surface side among the stacked plurality of sheet members, by using the dielectric material as the attracting surface.

Of those features, in order to cause the electrostatic attractive force to occur between the electrodes of the facing sheet members, it is only necessary to generate positive and negative electric charges in the surfaces of the facing dielectric materials by, for example, applying voltages having different polarities between those electrodes, and there is no particular limitation imposed on the shape or the like of the electrode.

Further, as for the outermost sheet member including the dielectric material which is to serve as the attracting surface, in order to generate, with respect to the electrode of the sheet member facing the same, the attractive force which reaches the attracting surface side, it is preferred that the electrode having the plurality of opening portions be provided so that the electric lines of force generated between the electrodes of the facing sheet members can reach the attracting surface side. In order to obtain a larger attractive force, it is preferred that the sheet member stacked so as to face the outermost sheet member including the electrode having the opening portions be configured to have the electrode existing at least at the position corresponding to the opening portion of the electrode of the outermost sheet member. In other words, when the opening portion is projected in the thickness direction, it is preferred that the facing sheet member be configured to have the electrode existing at the projected position. Note that, it is to be understood that, in the case where the outermost sheet members both include the electrode having the opening portions, the electrostatic attracting structure can be used as a double-sided attracting structure which attracts the object to be attracted on both top and back surfaces.

As the electrode having the plurality of opening portions, there can be given as examples such patterned electrodes as meshed electrode having a plurality of opening portions in a predetermined shape such as a circle, a lattice-shaped electrode, and a comb-shaped electrode. However, the present invention is not limited thereto, and the number, the size, the shape, and the like of the opening portions may be appropriately set in accordance with the type, the size, and the like of the object to be attracted. On the other hand, the electrode of the sheet member which is not used for attracting the object to be attracted may be an electrode having a plurality of opening portions, or a flat electrode having no opening portion may be provided.

As for the attraction power source for applying a voltage between the electrodes of the facing sheet members, the same attraction power source as is used in a general electrostatic attracting structure may be used. Further, the electrostatic attracting structure may include a solar cell for generating power by converting light energy into electrical energy, and a voltage boost circuit for boosting power generated by the solar cell to a necessary voltage. When a voltage is applied between the electrodes of the facing sheet members, one attraction power source may be used for each of the facing sheet members, or a voltage may be applied between the electrodes of all the facing sheet members by using one attraction power source. Here, according to the present invention, a voltage is applied between the electrodes of the facing sheet members by the attraction power source, thereby attracting the facing sheet members to each other, and also causing the attractive force with respect to the object to be attracted to occur on the attracting surface side. However, for example, the sheet member may include bipolar electrodes, and, by applying a voltage between the electrodes in the sheet member, the attractive force may be caused to occur between the facing sheet members, and also, the attractive force with respect to the object to be attracted may be caused to occur on the attracting surface side.

The dielectric material forming the sheet member is not particularly limited by the material, the fabrication method, or the like, and may be appropriately set in accordance with the type of the object to be attracted, the intended use of the electrostatic attracting structure, and the like. Typical examples thereof include an insulating film made of, for example, polyimide, a ceramic plate, a ceramic thermal-sprayed film formed by thermal-spraying ceramic powder such as alumina powder (Al₂O₃), aluminum nitride powder (AlN), or zirconia powder (ZrO₂). However, in a case where the dielectric material is used in an exhibition apparatus which attracts an exhibit or the like made of a paper or resin sheet material and is used indoors or outdoors, a dust collecting apparatus for attracting dirt and dust in the air, and such other apparatus, there is no need to consider an influence or the like of plasma irradiation which occurs in the semiconductor fabricating process, and hence the dielectric material may be formed by using, for example, polyethylene terephthalate (PET), polyester, an acrylic resin, an epoxy resin, polyethylene, celluloid, or a plastic film made of, for example, polyvinyl chloride, or printing insulating ink. Further, the thickness of the dielectric material varies depending on the used material, the intended use of the structure, and the like, but, for example, when the dielectric material is used in the exhibition apparatus, the dust collecting apparatus, or such other apparatus which is used indoors or outdoors, it is preferred that the structure include the dielectric materials each having a thickness of about from 20 to 70 µm with the use of the PET film or the insulating ink. Note that, the two dielectric materials which sandwiches the electrode may be made of different materials, and further, each of the dielectric materials may be formed of a plurality of (two or more) layers.

Further, as for the electrode constituting the sheet member, there is no particular limitation on the material, the fabrication method, and the like. For example, the electrode may be obtained by etching a metal foil or metal deposited by sputtering, ion plating, or the like, into a predetermined shape, or the predetermined shape may be obtained by thermal-spraying a metal material or printing conductive ink. The thickness of the electrode varies also depending on the intended use of the structure and the like, but, in general, it is preferred that the thickness be of about from 5 to 20 µm.

According to the present invention, the stacked sheet members are electrically attracted and fixed onto each other through the application of voltage between the electrodes of the sheet members by the attraction power source. However, when the sheet members are stacked, the sheet members may be fixed by fixing unit in advance after being subjected to positioning among one another. Such fixing unit is preferably such unit that is capable of keeping the state obtained after the positioning until a voltage is applied to each of the electrodes of the stacked sheet members and is also capable of separating the sheet members after the application of the voltage is canceled. The fixing unit is so-called temporary holding unit, and, for example, a double-faced pressure-sensitive tape having a pressure-sensitive adhesive applied to both sides thereof may be preferably used.

The electrostatic attracting structure of the present invention is capable of attracting the object to be attracted while maintaining a strongly integrated structure when used, and is also capable of separating the stacked plurality of sheet members from one another by canceling the application of voltage after the use. Therefore, for example, the following can be performed easily: part of the stacked sheet members is turned over to use another dielectric material as a new attracting surface; the order in which the sheet members are stacked is changed; and only part of the sheet members is replaced with another sheet member. Further, the number of sheet members to be stacked can be increased or decreased easily, and hence the attractive force to be generated can be changed in accordance with, for example, the type, the size, or the like of the object to be attracted.

### Advantageous Effects of Invention

According to the electrostatic attracting structure of the present invention, when used, a strongly integrated structure in which the electrodes are arranged on both sides of the dielectric materials is maintained, and the dielectric material of the outermost sheet member is used as the attracting surface to attract the object to be attracted. After the use, the sheet members can be separated easily. Therefore, the configuration of the structure itself can be changed freely. Further, according to the method of fabricating the electrostatic attracting structure of the present invention, it is possible to obtain the electrostatic attracting structure in which the electrodes are arranged one above the other with the intermediation of the dielectric material easily and reliably, and it is also possible to obtain the electrostatic attracting structure which allows the configuration change of the structure itself to be performed freely.

### Brief Description of Drawings

[FIGS. 1] FIGS. 1 are explanatory cross-sections for describing an electrostatic attracting structure adopted as attracting and holding means to an electrostatic chuck apparatus according to a first embodiment of the present invention.
[FIGS. 2] FIGS. 2 are explanatory plan views (A) and (B) of electrodes adopted to the electrostatic attracting structure according to the first embodiment of the present invention.
[FIG. 3] FIG. 3 is an explanatory cross-section for describing an exhibition/information apparatus according to a second embodiment of the present invention.
[FIGS. 4] FIGS. 4 are explanatory plan views (A) and (B) of electrodes adopted to an electrostatic attracting structure according to the second embodiment of the present invention.
[FIG. 5] FIG. 5 is an explanatory diagram for describing the electrostatic attracting structure according to the second embodiment of the present invention.
[FIG. 6] FIG. 6 is an explanatory cross-section for describing an electrostatic attracting structure according to a third embodiment of the present invention.

### Description of Embodiments

Hereinbelow, with reference to embodiments illustrated in the attached drawings, specific description is given of preferred embodiment modes of an electrostatic attracting structure and a method of fabricating the same according to the present invention.

### [First embodiment]

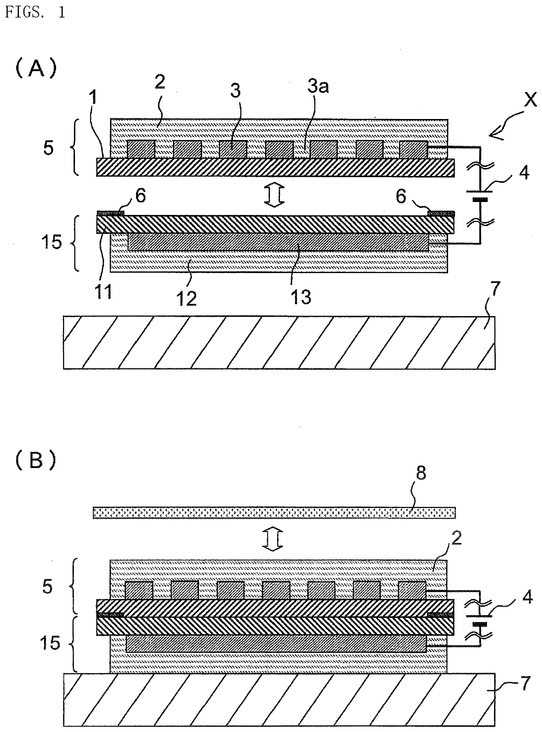

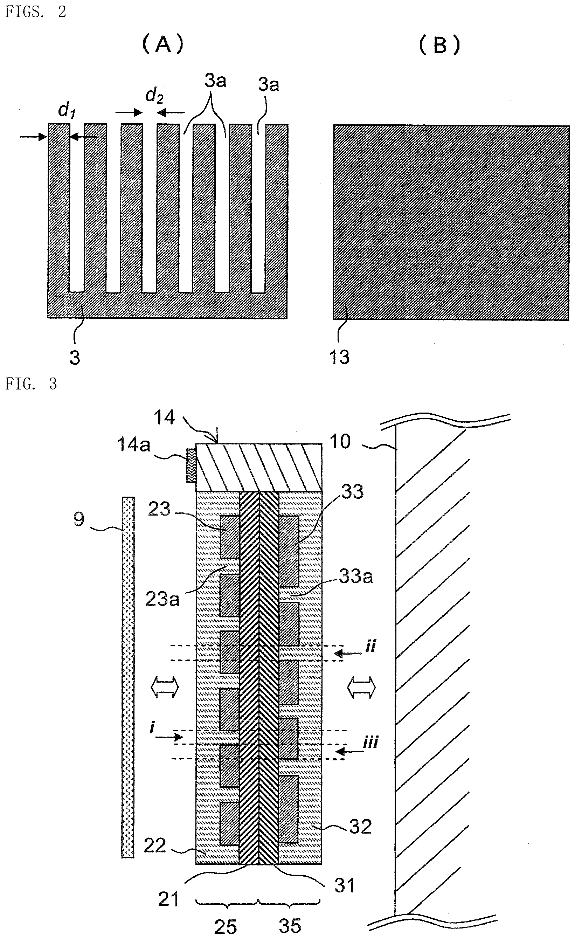

In FIGS. 1 and FIGS. 2, there is illustrated an electrostatic chuck apparatus which uses an electrostatic attracting structure X according to a first embodiment of the present invention as means for attracting and holding a semiconductor substrate such as a silicon wafer in a semiconductor fabricating process such as plasma etching.

In the electrostatic chuck apparatus of the first embodiment, the electrostatic attracting structure X serving as the above-mentioned means for attracting and holding the semiconductor substrate includes sheet members 5 and 15 and an attraction power source 4, and is integrally formed with an aluminum base 7 provided with piping (not shown) or the like for a coolant to flow through, thereby constituting the electrostatic chuck apparatus. The electrostatic attracting structure X is capable of attracting and holding a semiconductor substrate 8 such as a silicon wafer by using a dielectric material 2 of the sheet member 5 of the electrostatic attracting structure X as an attracting surface.

Here, the sheet member 5 is obtained by: depositing copper onto a surface of a dielectric material 1 made of a polyimide film having the dimensions of 320 mm (length) × 320 mm (width) × 50 µm (thickness) and then etching the copper into a predetermined shape to form an electrode 3 being 300 mm (length) × 300 mm (width) × 3 µm (thickness); and further laminating a polyimide film through the intermediation of a bonding sheet (not shown) so as to cover the electrode 3, thereby forming the dielectric material 2 being 320 mm (length) × 320 mm (width) × 50 µm (thickness). Of those, as illustrated in a plan view of FIG. 2(A), the electrode 3 includes a plurality of opening portions 3a, and is formed in a comb shape having an electrode width d₁ of 3 mm and an opening width d₂ of 1 mm. As illustrated in a plan view of FIG. 2(B), the other sheet member 15 is the same as the sheet member 5 except that a flat electrode 13, which has no opening portion and is 300 mm (length) × 300 mm (width) × 3 µm (thickness), is formed by depositing copper. The sheet member 15 includes a dielectric material 11, which is made of a polyimide film and has a thickness of 50 µm, and a dielectric material 12, which is made of a polyimide film as well and has a thickness of 50 µm.

Then, in order to form the electrostatic chuck apparatus, as illustrated in FIG. 1(A), after the dielectric material 12 side of the sheet member 15 is bonded to the aluminum base 7 through the intermediation of an adhesive sheet (not shown), double-faced pressure-sensitive tapes 6 are attached to edge portions of the dielectric material 11 so that, while positioning is performed on the other sheet member 5, the dielectric material 1 side is overlaid and fixed. Further, between the electrode 3 of the sheet member 5 and the electrode 13 of the sheet member 15, the DC power source (attraction power source) 4 is connected via a connection terminal and a switch (both not shown), and a voltage of +1 kV and a voltage of -1 kV can be applied to the electrode 3 and the electrode 13, respectively.

Therefore, according to the electrostatic chuck apparatus of the first embodiment, as illustrated in FIG. 1(B), when the attraction power source 4 constituting the electrostatic attracting structure X is switched on to apply the above-mentioned voltages to the electrode 3 and the electrode 13, an electrostatic attractive force is generated between the sheet member 5 and the sheet member 15, which are thus attracted and fixed onto each other. At the same time, electric lines of force which are generated between the electrode 3 and the electrode 13 reach the dielectric material 2 of the sheet member 5 through the opening portions 3a to cause an attractive force to occur, and hence it is possible to attract the semiconductor substrate 8.

Then, after predetermined processing such as plasma etching is performed on the semiconductor substrate 8 attracted to the electrostatic attracting structure X, if the switch of the attraction power source 4 is opened to stop the application of voltage, the semiconductor substrate 8 can be removed from the dielectric material 2. At the same time, the electrostatic attractive force generated between the sheet members 5 and 15 disappears, and hence the sheet member 5 can also be removed. Accordingly, for example, when the wearing out of the dielectric material 2 has progressed, by replacing only the sheet member 5 with another sheet member, it is possible to use the electrostatic attracting structure X again almost in mint condition.

### [Second embodiment]

In FIGS. 3 to 5, there is illustrated an exhibition/information apparatus in which an electrostatic attracting structure X according to a second embodiment of the present invention is used as display means for exhibit and information.

In the exhibition/information apparatus of the second embodiment, the electrostatic attracting structure X serving as the above-mentioned display means includes sheet members 25 and 35 and an attraction power source 14, and it is possible to attract a dielectric material 32 side of the sheet member 35 to, for example, a wall surface 10 while information 9 made of paper or a resin sheet is attracted to a dielectric material 22 side of the sheet member 25.

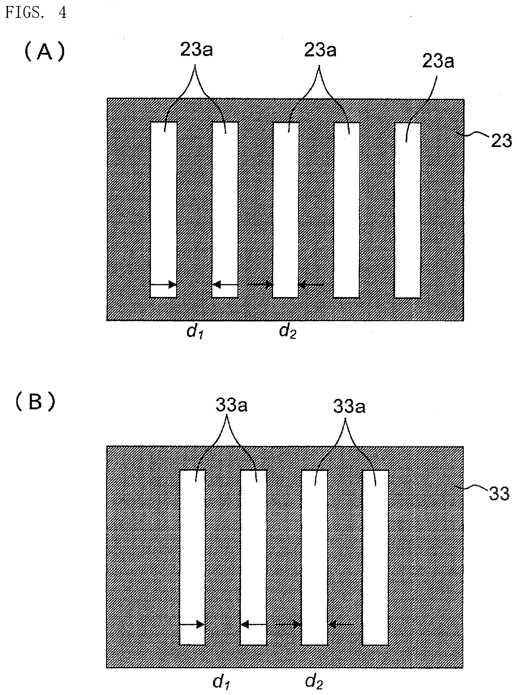

Here, the sheet member 25 is obtained by: screen-printing carbon ink (manufactured by JUJO CHEMICAL CO., LTD.: JELCON CH-10) onto a PET film (dielectric material) 21 having the dimensions of 400 mm (length) × 600 mm (width) × 50 µm (thickness) to form an electrode 23 being 350 mm (length) × 550 mm (width) × 10 µm (thickness); and further screen-printing insulating ink (manufactured by JUJO CHEMICAL CO., LTD.: JELCON AC-3G) so as to cover the electrode 23, thereby forming the dielectric material 22 being 400 mm (length) × 600 mm (width) × 50 µm (thickness). Of those, as illustrated in a plan view of FIG. 4(A), the electrode 23 is formed so as to include a plurality of opening portions 23a and have an electrode width d₁ of 3 mm and an opening width d₂ of 1 mm. As illustrated in a plan view of FIG. 4(B), the other sheet member 35 is formed in the same manner as the sheet member 25, with the electrode 33 having an electrode width d₁ of 3 mm and an opening width d₂ of 1 mm and including a plurality of opening portions 33a, except that the positions of the opening portions 33a are made different from the pattern of the electrode 23.

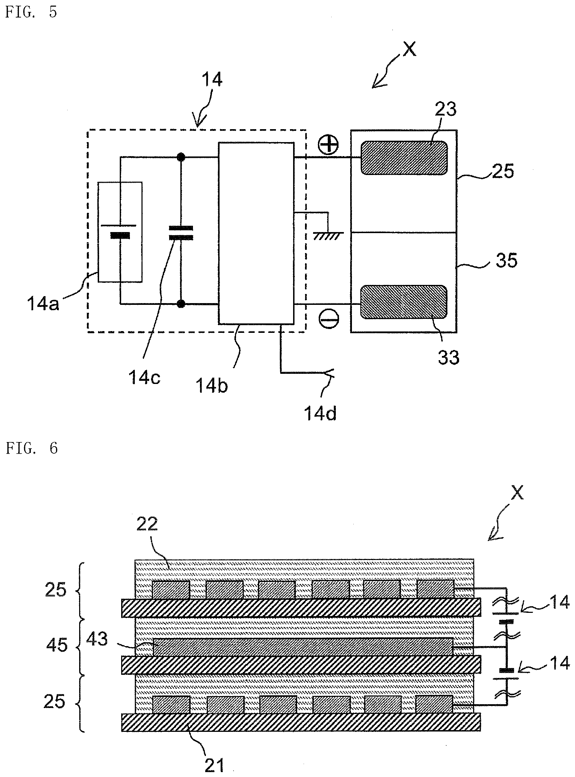

Further, in the exhibition/information apparatus of the second embodiment, a solar cell is used as the attraction power source 14 constituting the electrostatic attracting structure X. As illustrated in FIG. 5, the attraction power source 14 includes a solar cell 14a and a voltage boost circuit 14b for power generated by the solar cell 14a. Further, the attraction power source 14 includes a large-capacity capacitor 14c having an energy capacity of 200 mWh so that, by storing power generated by the solar cell 14a, voltages can be applied to the above-mentioned electrode 23 and electrode 33 even when the power generation capability of the solar cell 14a is temporarily suspended or decreased. In addition, to the voltage boost circuit 14b, there is provided a power source switch 14d for turning on/off the application of voltage to the electrodes 23 and 33.

Note that, in the exhibition/information apparatus of the second embodiment, the sheet members 25 and 35 and the attraction power source 14, which constitute the electrostatic attracting structure X, are integrally formed, but those components only need to be connected to each other so that voltages are applied to the electrode 23 and the electrode 33 of the respective sheet members. Those components may be connected by a relatively long connection cable so as to install the attraction power source 14 in a place convenient for the solar cell 14a to generate power.

Then, in order to form the exhibition/information apparatus, while being fixed by, for example, a double-faced pressure-sensitive tape (not shown), the PET film 21 of the sheet member 25 is overlaid on the PET film 31 of the sheet member 35 for positioning. On this occasion, in the positioning, the sheet member 35 is positioned so that the electrode exists at positions corresponding to the opening portions 23a of the electrode 23 constituting the sheet member 25, and also the sheet member 25 is positioned so that the electrode exists at positions corresponding to the opening portions 33a of the electrode 33 constituting the sheet member 35. Specifically, as illustrated in FIG. 3, when viewed in cross-section which includes the opening portions of both electrodes, both the electrodes 23 and 33 have gaps each being 1 mm wide, and are formed so that portions corresponding to the gaps of one electrode are covered with the other electrode through the intermediation of the PET films 21 and 31 of the sheet members facing each other. The positioning is performed as follows. That is, as indicated by an arrow i in FIG. 3, at a position obtained by projecting the opening portion 23a of the electrode 23 of the sheet member 25 in a thickness direction, the electrode 33 of the sheet member 35 exists, whereas, similarly, as indicated by an arrow ii, at a position obtained by projecting the opening portion 33a of the electrode 33 of the sheet member 35 in the thickness direction, the electrode 23 of the sheet member 25 exists. Note that, as indicated by an arrow iii, a portion where the electrode 23 and the electrode 33 overlap each other in the thickness direction is set to 1 mm on both sides.

Therefore, according to the exhibition/information apparatus of the second embodiment, first, in a state in which the power source switch 14d is off, the dielectric material 32 side of the overlaid sheet member 25 and sheet member 35 is placed on a predetermined part of the wall surface 10 after the positioning. Under this state, the power source switch 14d is then turned on, to thereby cause the sheet member 25 and the sheet member 35 to be electrically attracted and fixed onto each other through the application of voltage between the electrodes 23 and 33, and at the same time, to cause the electrostatic attracting structure X to be attracted and fixed onto the wall surface 10. In addition, the information 9 is attached to the surface of the dielectric material 22 of the sheet member 25 for display.

Then, for example, when the surface of the dielectric material 22 of the sheet member 25 has become contaminated due to outdoor display of the information 9 for a predetermined period, the power source switch 14d may be turned off to remove the information 9 temporarily, and also, the electrostatic attracting structure X may be removed from the wall surface 10. When used, for example, the electrostatic attracting structure X may be turned over to make the dielectric material 22 side of the sheet member 25 face the wall surface 10. Then, the information 9 may be attached to the dielectric material 32 of the sheet member 35. Alternatively, by turning over only the sheet member 25, the electrostatic attracting structure X may be formed by making the dielectric material 22 of the sheet member 25 and the PET film 31 of the sheet member 35 face each other so that the PET film 21 side becomes the attracting surface for the information.

### [Third embodiment]

In FIG. 6, there is illustrated a modification example of the electrostatic attracting structure X used in the second embodiment described above. An electrostatic attracting structure X according to a third embodiment is formed by stacking three sheet members. That is, two sheet members 25 each constituting the electrostatic attracting structure X of the second embodiment are used, and further, between those sheet members, a sheet member 45 is interposed. Of those, the sheet member 45 is formed in the same manner as the sheet member 25 except that the sheet member 45 includes an electrode 43 being 350 mm (length) × 550 mm (width) × 10 µm (thickness), whose entire surface serves as the electrode with no opening portion formed therein. Further, the electrostatic attracting structure X according to the third embodiment is formed in the same manner as in the second embodiment except that two attraction power sources 14 are used to apply a voltage between electrodes of the sheet members facing each other.

Then, with the electrostatic attracting structure X according to the third embodiment, compared to that of the second embodiment, an attractive force generated between the sheet members facing each other can be made larger, and hence it is possible to use the electrostatic attracting structure X in more varied ways by changing its application purpose, intended use, or the like, such as increasing the electrostatic attracting structure X itself in size to allow larger information or the like to be attracted.

Note that, it is to be understood that the electrostatic attracting structures X of the present invention which have been described in the first to third embodiments may be used for other application purposes than the apparatuses respectively described above. In addition to still another application purpose in the semiconductor fabricating process, the field of liquid crystal fabrication, and the like, such as the substrate transport apparatus, the electrostatic attracting structure X may be used, for example, as an air cleaning apparatus for collecting dust and dirt in the air, and eradicating or sterilizing viruses, pathogenic bacteria, and the like. Further, the electrostatic attracting structure X may be used as an apparatus which is used in water or a liquid for collecting metal or the like in the liquid, or may be used as a filings removing apparatus or the like for removing filings or the like produced in various shop-floors.

### Reference Signs List

1, 2, 11, 12: dielectric material
3, 13, 23, 33, 43: electrode
3a, 23a, 33a: opening portion
4, 14: attraction power source
14a: solar cell
14b: voltage boost circuit
14c: large-capacity capacitor
14d: power source switch
5, 15, 25, 35, 45: sheet member
6: double-faced pressure-sensitive tape
7: metal base
8: semiconductor substrate
9: information
10: wall surface
X: electrostatic attracting structure

## Claims

1. An electrostatic attracting structure, which is configured for electrically attracting an object to be attracted when used, comprising:
a plurality of sheet members (5, 15, 25, 35, 45) each having an electrode (3, 13, 23, 33, 43) which is sandwiched between two dielectric materials (1, 2, 11, 12, 21, 22, 31, 32), the plurality of sheet members being stacked; and
at least one attraction power source (4, 14) for applying a voltage between the electrodes of facing sheet members,
wherein the facing sheet members (5, 15, 25, 35, 45) are designed for being electrically attracted and fixed, by applying the voltage between the electrodes (3, 13, 23, 33, 43) of the facing sheet members,
wherein, when the electrostatic attracting structure is used, the dielectric materials (1, 2, 11, 12, 21, 22, 31, 32) of both of outermost sheet members including a sheet member corresponding to an outermost top surface layer and a sheet member corresponding to an outermost back surface layer are designed for attracting the object to be attracted, and
wherein, after the use, the stacked plurality of sheet members (5, 15, 25, 35, 45) are designed for being separated from one another by canceling the application of the voltage.

2. An electrostatic attracting structure according to claim 1,
wherein both of the outermost sheet members (25, 35) each comprise an electrode (23, 33) having a plurality of opening portions (23a, 33a), and
wherein a sheet member (25, 35, 45) stacked so as to face each outermost sheet member comprising the electrode having the plurality of opening portions is configured so that the electrode (23, 33, 43) exists at least at positions corresponding to the plurality of opening portions.

3. An electrostatic attracting structure according to claim 1 or 2, wherein the plurality of sheet members (5, 15, 25, 35, 45) are fixed by fixing unit after being subjected to positioning among one another.

4. An electrostatic attracting structure according to claim 1 or 2, wherein the electrostatic attracting structure is formed by stacking a plurality of sheet members (5, 15, 25, 35, 45) each obtained by printing conductive ink onto an insulating film to form a predetermined electrode and printing insulating ink so as to cover the predetermined electrode.

5. An electrostatic attracting structure according to claim 4, wherein the electrostatic attracting structure has two sheet members (25, 35) overlaid on each other, the two sheet members each being obtained by forming the predetermined electrode (23, 33) having a plurality of opening portions (23a, 33a) by printing the conductive ink onto the dielectric material (21, 31) formed of the insulating film, and printing the insulating ink so as to cover the predetermined electrode, thereby forming a dielectric material (22, 32), whereby the object to be attracted can be attracted onto the dielectric materials on both a top surface and a back surface.

6. An electrostatic attracting structure according to claim 5,
wherein the dielectric material (21, 31) formed of the insulating film has a thickness of from 20 to 70 µm,
wherein the dielectric material formed of the insulating ink (22, 32) has a film thickness of from 20 to 70 µm, and
wherein the electrode (23, 33) formed of the conductive ink has a film thickness of from 5 to 20 µm.

7. A method of fabricating the electrostatic attracting structure according to any one of claims 1 to 6, comprising:
stacking a plurality of sheet members (5, 15, 25, 35, 45) by subjecting the plurality of sheet members to positioning among one another;
electrically attracting and fixing facing sheet members (5, 15, 25, 35, 45) and forming the facing sheet members into an integrated structure by applying a voltage between electrodes (3, 13, 23, 33, 43) of the facing sheet members by an attraction power source (4, 14); and
making the stacked plurality of sheet members (5, 15, 25, 35, 45) separable from one another after the application of the voltage is canceled.

## Patentansprüche

1. Elektrostatisch anziehende Struktur, die zum elektrischen Anziehen eines Objekts konfiguriert ist, das angezogen werden soll, wenn es verwendet wird, die aufweist:
eine Vielzahl von Plattenelementen (5, 15, 25, 35, 45), die jeweils eine Elektrode (3, 13, 23, 33, 43) aufweisen, die zwischen zwei dielektrische Materialien (1, 2, 11, 12, 21, 22, 31, 32) eingelegt ist, wobei die Vielzahl der Plattenelemente aufeinandergeschichtet sind; und
mindestens eine Anziehungsstromquelle (4, 14) zum Anlegen einer Spannung zwischen die Elektroden von gegenüberliegenden Plattenelementen,
wobei die gegenüberliegenden Plattenelemente (5, 15, 25, 35, 45) dazu bestimmt sind, durch Anlegen der Spannung zwischen den Elektroden (3, 13, 23, 33, 43) der gegenüberliegenden Plattenelemente elektrisch angezogen und fixiert zu werden, wobei, wenn die elektrostatisch anziehende Struktur verwendet wird, die dielektrischen Materialien (1, 2, 11, 12, 21, 22, 31, 32) von beiden äußersten Plattenelementen, die ein Plattenelement, das einer äußersten Oberseitenschicht entspricht, und ein Plattenelement einschließen, das einer äußersten Rückseitenschicht entspricht, zum Anziehen des Objekts bestimmt sind, das angezogen werden soll, und
wobei nach dem Gebrauch die aufeinandergeschichtete Vielzahl der Plattenelemente (5, 15, 25, 35, 45) dazu bestimmt sind, durch Aufheben des Anlegens der Spannung voneinander getrennt zu werden.

2. Elektrostatisch anziehende Struktur nach Anspruch 1,
wobei beide äußersten Plattenelemente (25, 35) jeweils eine Elektrode (23, 33) aufweisen, die eine Vielzahl von Öffnungsabschnitten (23a, 33a) aufweisen, und
wobei ein Plattenelement (25, 35, 45), das aufeinandergeschichtet ist, dass es jedem äußersten Plattenelement gegenüberliegt, das die Elektrode aufweist, die die Vielzahl der Öffnungsabschnitte aufweist, so konfiguriert ist, dass die Elektrode (23, 33, 43) mindestens an Positionen vorhanden ist, die der Vielzahl der Öffnungsabschnitte entsprechen.

3. Elektrostatisch anziehende Struktur nach Anspruch 1 oder 2, wobei die Vielzahl der Plattenelemente (5, 15, 25, 35, 45) durch eine Fixierungseinheit fixiert werden, nachdem sie einer Positionierung zueinander unterzogen worden sind.

4. Elektrostatisch anziehende Struktur nach Anspruch 1 oder 2, wobei die elektrostatisch anziehende Struktur durch Aufeinanderschichten einer Vielzahl von Plattenelementen (5, 15, 25, 35, 45) gebildet wird, die jeweils durch Drucken einer leitfähigen Tinte auf einen isolierenden Film, um eine vorgegebene Elektrode zu bilden, und durch Drucken einer isolierenden Tinte erhalten werden, um die vorgegebene Elektrode abzudecken.

5. Elektrostatisch anziehende Struktur nach Anspruch 4, wobei die elektrostatisch anziehende Struktur zwei Plattenelemente (25, 35) aufweist, die übereinander liegen, wobei die beiden Plattenelemente jeweils durch Bilden der vorgegebenen Elektrode (23, 33), die eine Vielzahl von Öffnungsabschnitten (23a, 33a) aufweist, durch Drucken der leitfähigen Tinte auf das dielektrische Material (21, 31), das aus dem isolierenden Film ausgebildet ist, und Drucken der isolierenden Tinte erhalten werden, um die vorgegebene Elektrode abzudecken, wodurch ein dielektrisches Material (22, 32) gebildet wird, wodurch das Objekt, das angezogen werden soll, an die dielektrischen Materialien sowohl auf einer Oberseite als auch auf einer Rückseite angezogen werden kann.

6. Elektrostatisch anziehende Struktur nach Anspruch 5,
wobei das dielektrische Material (21, 31), das aus dem isolierenden Film ausgebildet ist, eine Dicke von 20 bis 70 µm aufweist,
wobei das dielektrische Material, das aus der isolierenden Tinte (22, 32) ausgebildet ist, eine Filmdicke von 20 bis 70 µm aufweist, und
wobei die Elektrode (23, 33), die aus der leitfähigen Tinte ausgebildet ist, eine Filmdicke von 5 bis 20 µm aufweist.

7. Verfahren zum Herstellen der elektrostatisch anziehenden Struktur nach einem der Ansprüche 1 bis 6, das aufweist:
Aufeinanderschichten einer Vielzahl von Plattenelementen (5, 15, 25, 35, 45) durch Unterziehen der Vielzahl der Plattenelemente einer Positionierung zueinander;
elektrisches Anziehen und Fixieren der gegenüberliegenden Plattenelemente (5, 15, 25, 35, 45) und Ausbilden der gegenüberliegenden Plattenelemente zu einer integrierten Struktur durch Anlegen einer Spannung zwischen Elektroden (3, 13, 23, 33, 43) der gegenüberliegenden Plattenelemente durch eine Anziehungsstromquelle (4, 14); und
Bewirken, dass die aufeinandergeschichtete Vielzahl der Plattenelemente (5, 15, 25, 35, 45) voneinander trennbar sind, nachdem das Anlegen der Spannung aufgehoben wird.

## Revendications

1. Structure d'attraction électrostatique, prévue pour attirer électriquement un objet à attirer pour utilisation, comprenant :
une pluralité d'éléments en feuille (5, 15, 25, 35, 45) pourvus chacun d'une électrode (3, 13, 23, 33, 43) intercalée entre deux matériaux diélectriques (1, 2, 11, 12, 21, 22, 31, 32), les éléments en feuille de ladite pluralité étant empilés ; et
au moins une source de courant d'attraction (4, 14) pour l'application d'une tension entre les électrodes d'éléments en feuille opposés,
où les éléments en feuille opposés (5, 15, 25, 35, 45) sont prévus pour être attirés électriquement et fixés par application de la tension entre les électrodes (3, 13, 23, 33, 43) des éléments en feuille opposés,
où, quand la structure d'attraction électrostatique est utilisée, les matériaux diélectriques (1, 2, 11, 12, 21, 22, 31, 32) des deux éléments en feuille les plus extérieurs comprenant un élément en feuille correspondant à une couche de surface extérieure supérieure et un élément en feuille correspondant à une couche de surface le plus extérieure arrière sont prévus pour attirer l'objet à attirer, et
où, après utilisation, les éléments de la pluralité d'éléments en feuille empilés (5, 15, 25, 35, 45) sont prévus pour être séparés l'un de l'autre en arrêtant l'application de tension.

2. Structure d'attraction électrostatique selon la revendication 1,
où les deux éléments en feuille les plus extérieurs (25, 35) comprennent chacun une électrode (23, 33) présentant une pluralité de sections d'ouverture (23a, 33a), et
où un élément en feuille (25, 35, 45) empilé de manière à être opposé à chaque élément en feuille le plus extérieur comprenant l'électrode présentant la pluralité de sections d'ouverture, est configuré de telle manière que l'électrode (23, 33, 43) soit présentée au moins à des emplacements correspondant à la pluralité de sections d'ouverture.

3. Structure d'attraction électrostatique selon la revendication 1 ou la revendication 2, où les éléments en feuille (5, 15, 25, 35, 45) de la pluralité sont fixés par un moyen de fixation après avoir été positionnés les uns par rapport aux autres.

4. Structure d'attraction électrostatique selon la revendication 1 ou la revendication 2, où la structure d'attraction électrostatique est formée en empilant une pluralité d'éléments en feuille (5, 15, 25, 35, 45) obtenus chacun par impression d'une encre conductrice sur un film isolant pour former une électrode définie et par impression d'encre isolante de manière à couvrir l'électrode définie.

5. Structure d'attraction électrostatique selon la revendication 4, où la structure d'attraction électrostatique comprend deux éléments en feuille (25, 35) superposés l'un à l'autre, lesdits deux éléments en feuille étant obtenus chacun en formant l'électrode définie (23, 33) ayant une pluralité de sections d'ouverture (23a, 33a) par impression de l'encre conductrice sur le matériau diélectrique (21, 31) constitué par le fil isolant, et par impression de l'encre isolante de manière à couvrir l'électrode définie, en formant ainsi un matériau diélectrique (22, 32), l'objet à attirer pouvant l'être sur les matériaux diélectriques par une surface supérieure et une surface arrière.

6. Structure d'attraction électrostatique selon la revendication 5,
où le matériau diélectrique (21, 31) formé par le film isolant a une épaisseur comprise entre 20 et 70 µm,
où le matériau diélectrique formé par l'encre isolante (22, 32) a une épaisseur de film comprise entre 20 et 70 µm, et
où l'électrode (23, 33) formée par l'encre conductrice a une épaisseur de film comprise entre 5 et 20 µm.

7. Procédé de fabrication de la structure d'attraction électrostatique selon l'une des revendications 1 à 6, comprenant :
l'empilement d'une pluralité d'éléments en feuille (5, 15, 25, 35, 45) en positionnant les éléments de la pluralité d'éléments en feuille les uns par rapport aux autres ;
l'attraction électrique et la fixation d'éléments en feuille (5, 15, 25, 35, 45) opposés, et la formation des éléments en feuille opposés en une structure intégrée par application d'une tension entre électrodes (3, 13, 23, 33, 43) des éléments en feuille opposés par une source de courant d'attraction (4, 14) ; et
la réalisation d'une possibilité de séparation les uns des autres des éléments de la pluralité d'éléments en feuille (5, 15, 25, 35, 45) empilés après arrêt de l'application de tension.
